# EUROPEAN PATENT APPLICATION

(11) **EP 1 037 516 A2**
(43) Date of publication of application: **20.09.2000**
(21) Application number: 00301873.6
(22) Date of filing: 07.03.2000
(51) Int. Cl.: H05K 7/14

(54) **Circuit pack advanced guidance into guide slot and connector protection**

(30) Priority: 15.03.1999 US 268149
(71) Applicant: LUCENT TECHNOLOGIES INC., Murray Hill, New Jersey 07974-0636 (US)
(72) Inventor: Gangemi, Joseph L., Manalapan, NJ 07726 (US); Hwang, Liang, Old Bridge, NJ 08857 (US); Li, Hsiao C., Edison, NJ 08820 (US)
(74) Representative: Johnston, Kenneth Graham

(57) **Abstract**

A circuit card wherein tabs extend beyond the forward edge of the card and beyond the forward mating end of connectors mounted to the card to provide protection to the connectors and advanced guidance of the card into card cage guide slots.

## Description

### Background Of The Invention

This invention relates to a circuit pack adapted for insertion into a card cage guide slot and, more particularly, to advanced guidance of the circuit pack during such insertion and to protection of the circuit pack connector.

Modern electronic systems equipment, such as for telecommunications purposes, is often constructed as modular circuit packs inserted into guide slots of mechanical card cages for engagement with a backplane mounted to the card cage at the inward ends of the guide slots. Usually, the packaging requirements for such systems results in a high density of circuit packs, with minimum spacing between circuit packs. Each circuit pack includes a circuit board, at least one circuit component mounted to the circuit board, a connector secured to the circuit board along a forward edge of the board and circuitry connecting the circuit component to the connector. In advanced technology packaging, the surface of the connector may include conductive piece parts, such as circuit pack grounding shields needed for electromagnetic interference and/or improved signal quality, that can cause shorting of an adjacent circuit pack already installed in the card cage if the circuit pack being installed is not properly aligned upon insertion into a card cage guide slot. It would therefore be desirable to provide some way of preventing such shorting without increasing the spacing between adjacent circuit packs.

In addition, it has been found that inadvertent mishandling of the circuit pack can result in damage to the connector. It would also be desirable to provide protection to the connector from such mishandling.

### Summary Of The Invention

According to the present invention, the circuit board is extended along opposed edges beyond the circuit pack connector. The extensions provide advanced guidance of the circuit card into a guide slot of the card cage, insuring that the connector along the forward edge of the card is properly spaced from an adjacent circuit pack. In addition, the extensions provide protection to the connector from inadvertent mishandling.

### Brief Description Of The Drawings

The foregoing will be more readily apparent upon reading the following description in conjunction with the drawings in which like elements in different figures thereof are identified by the same reference numeral and wherein:
FIGURE 1 is a rear perspective view of a mechanical card cage, without the backplane installed;
FIGURE 2 is a front view of the card cage shown in Figure 1 with the backplane installed;
FIGURE 3 is a side view of a circuit pack having the present invention incorporated therein; and
FIGURE 4 is an enlarged partial side view of the circuit pack shown in Figure 3 showing the initial entry of the circuit pack into a guide slot of the card cage.

### Detailed Description

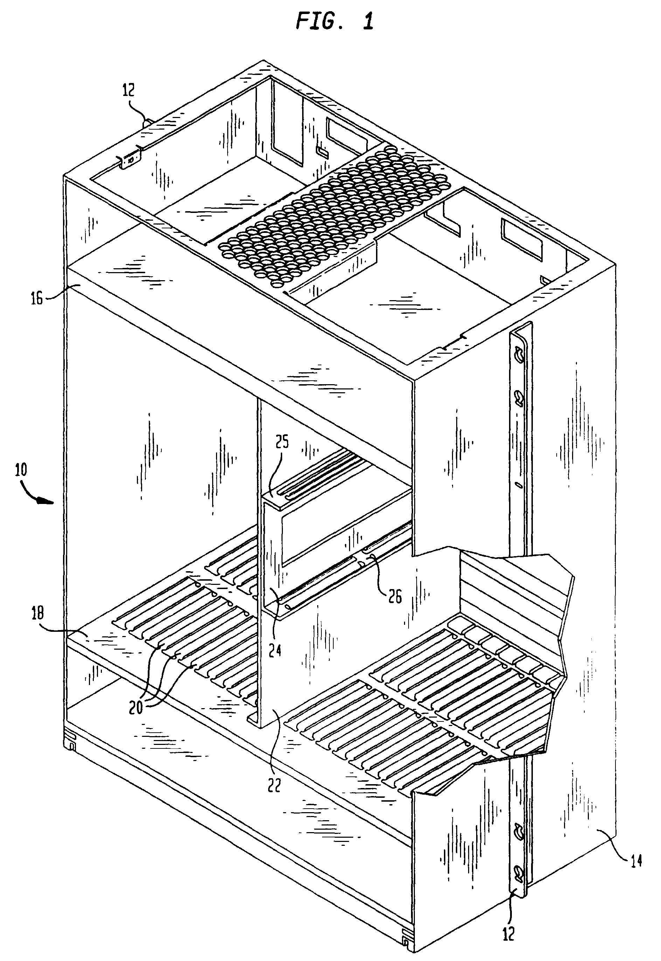

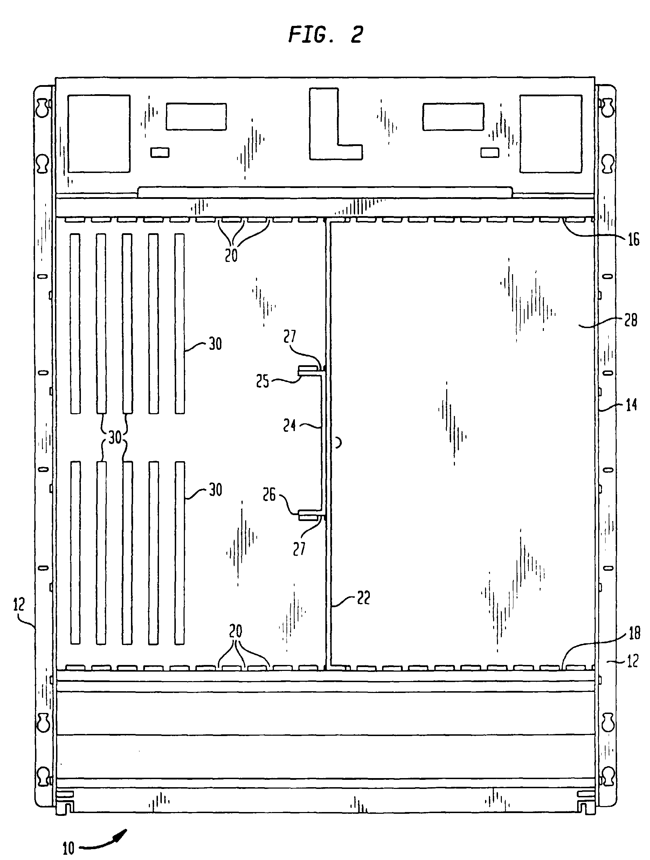

Referring now to the drawings, Figure 1 shows a card cage, designated generally by the reference numeral 10, with which the present invention finds utility. As is conventional, the card cage 10 is typically mounted to an equipment rack, by means of the flanges 12, and includes an exterior metal enclosure 14. The card cage 10 includes parallel spaced apart upper plate 16 and lower plate 18 secured to the enclosure 14. The upper and lower plates 16, 18 are substantially the same and provide a plurality of parallel guide slots 20 for a plurality of circuit packs. Illustratively, the plates 16, 18 are stamped and formed to have cutouts with upturned edges to provide the guide slots 20 between adjacent upturned edges. A separator plate 22 may be provided to which is secured a member 24 having opposed flanges 25, 26 on which are formed guide slots 27 so that smaller circuit packs may be accommodated in the card cage 10. As is conventional, mounted to the back of the enclosure 14 is a backplane 28, as shown in Figure 2. The backplane 28 is a planar circuit board having an array of connectors 30 secured thereto. The connectors 30 are so situated on the backplane 28 that when a circuit pack is inserted into a pair of opposed guide slots 20, the connector on the circuit pack engages respective connector(s) 30 upon being fully inserted into the enclosure 14.

The problem which the present invention solves arises due to the close spacing between adjacent guide slots 20. If a circuit pack is not initially inserted at the correct angle into a pair of guide slots, metal shielding on a circuit pack connector can inadvertently contact circuitry on an adjacent circuit pack.

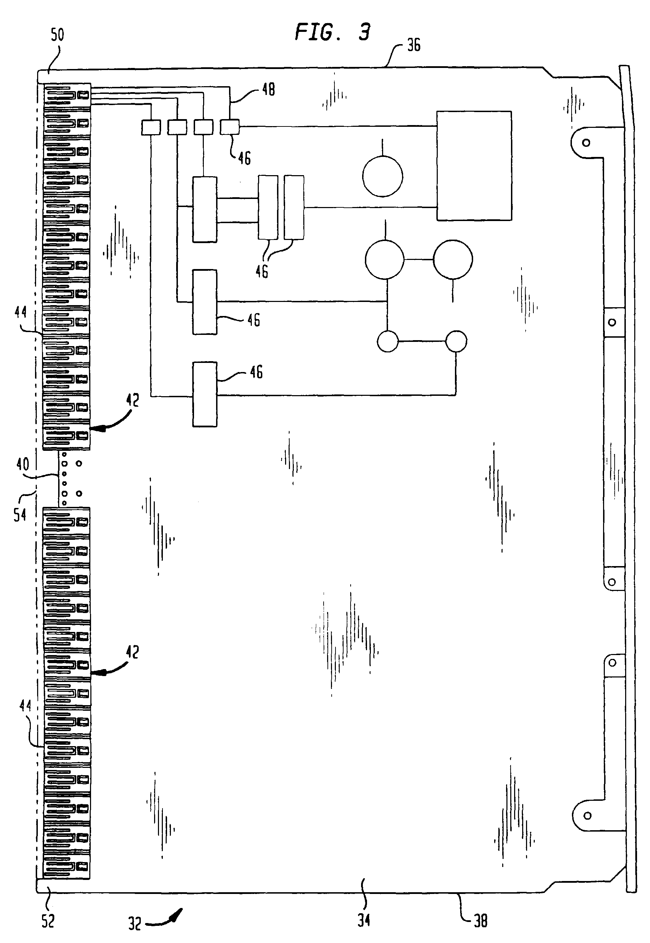

Figure 3 illustrates a circuit pack, designated generally by the reference numeral 32, in which is incorporated the present invention. The circuit pack 32 includes a circuit board 34 having a pair of opposed parallel side edges 36, 38, and a forward edge 40 extending between the side edges 36, 38. Connector arrays 42 are secured to the circuit board 34 and extend forwardly beyond the forward edge 40 of the board 34. The connector arrays 42 have a forward mating end 44 adapted to engage respective connectors 30 on the backplane 28. Circuit components 46 are mounted to the circuit board 34 and circuitry 48 on the board 34 connects the circuit components 46 to the connector array 42.

According to the present invention, the circuit board 34 is formed to have a pair of tabs 50, 52 which extend forwardly beyond the mating end 44 of the connector arrays 42. Each of the tabs 50, 52 has an edge which is an extension of a respective one of the side edges 36, 38. In effect, the forward edge 40 of the circuit card 34 is recessed over a portion of its length to form the tabs 50, 52. The tabs 50, 52 extend forwardly to a line 54 which is orthogonal to the side edges 36, 38, and the mating end 44 of the connector arrays 42 is between the line 54 and the forward edge 40 of the circuit card 34.

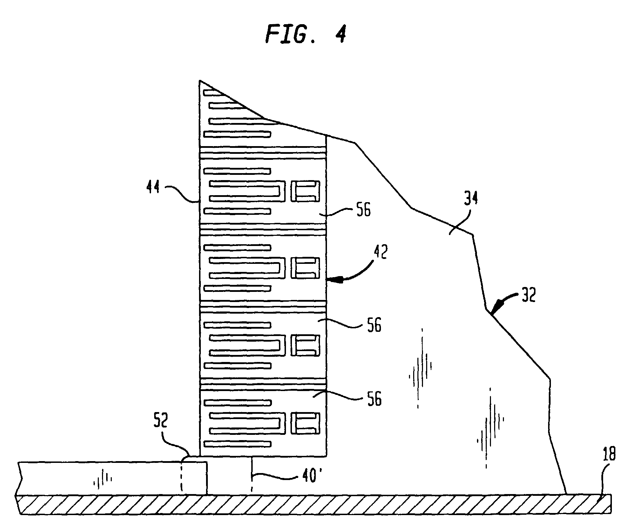

As shown in Figure 4, the tab 52 enters the guide slot in advance of the mating end 44 of the connector arrays 42. Thus, the circuit board 34 is properly aligned before the shielding 56 on the connector arrays 42 is inserted far enough to short an adjacent circuit pack. As shown in Figure 4, the broken line 40' is an extension of the forward edge 40 of the circuit card 34 and it is seen that without the tab 52 if the circuit card 34 was not properly in the guide slot until the forward edge 40 reached the beginning of the guide slot, the shielding 56 could be offset sufficiently to short an adjacent circuit pack.

In addition to providing advanced guidance for the circuit pack 32, the tabs 50, 52 provide a degree of protection to the connector arrays 42 against inadvertent mishandling.

Accordingly, there has been disclosed an improvement to a circuit pack which protects the connectors from inadvertent mishandling and provides advanced guidance of the circuit pack into guide slots of a card cage to prevent shorting of adjacent circuit packs. While an illustrative embodiment of the present invention has been disclosed, it is understood that various adaptations and modifications to the disclosed embodiment are possible and it is intended that this invention be limited only by the scope of the appended claims.

## Claims

1. A circuit card adapted to be inserted into a card cage, the card cage having a pair of opposed parallel guide slots for receiving opposed parallel side edges of the circuit card, the circuit card having a forward edge extending between the pair of side edges and a connector secured to the circuit card between the pair of side edges and extending forwardly beyond the forward edge of the card for engagement with a complementary mating connector on a backplane secured to the card cage, wherein the improvement comprises:
a pair of tabs formed as part of the circuit card, each of the tabs having an edge which is an extension of a respective one of the pair of side edges and each of the tabs extending forwardly beyond the connector between the connector and the respective one of the pair of side edges;
whereby the pair of tabs are effective to provide advanced guidance of the circuit card into the card cage guide slots.

2. A circuit pack comprising:
a circuit board having a pair of opposed parallel side edges and a forward edge extending between said pair of side edges, said circuit board forward edge being recessed over a portion of its length so as to provide a pair of forwardly extending tabs each having as one side edge a portion of a respective one of said pair of side edges and each having a forward edge;
a connector secured to said circuit board along said circuit board forward edge between said pair of tabs, said connector having a forward mating end lying between said circuit board forward edge and a line joining the forward edges of said pair of tabs;
at least one circuit component mounted to said circuit board; and
circuitry connecting said at least one circuit component to said connector.

3. A circuit board having a pair of opposed parallel side edges and a forward edge extending between said pair of side edges, each of said pair of side edges extending forwardly to a line orthogonal to said pair of side edges, and said forward edge being recessed along a central portion thereof rearwardly of said line so as to provide a pair of tabs each extending forwardly to said line, with each of said pair of tabs having a portion of a respective one of said board side edges as one of its side edges.

4. The circuit board according to Claim 3 further comprising:
a connector mounted to said circuit board along said forward edge central portion, said connector having a forward mating end between said forward edge central portion and said line.
